(19) Europäisches Patentamt
European Patent Office
Office européen des brevets

(11) **EP 4 766 051 A1**

(12) **EUROPEAN PATENT APPLICATION**

(43) Date of publication:
**24.06.2026 Bulletin 2026/26**

(21) Application number: **24307256.8**

(22) Date of filing: **20.12.2024**

(51) International Patent Classification (IPC):
**H05K 7/20** (2006.01)

(52) Cooperative Patent Classification (CPC):
**H05K 7/2079; H05K 7/20836**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **OVH**
**59100 Roubaix (FR)**

(72) Inventors:
• **CHEHADE, Ali**
**59283 Moncheaux (FR)**
• **HNAYNO, Mohamad**
**59110 La Madeleine (FR)**
• **BAUDUIN, Hadrien**
**59650 Villeneuve d'Ascq (FR)**

(74) Representative: **BCF Global**
**17-21, rue Saint-Fiacre**
**75002 Paris (FR)**

(54) **DATACENTER FAN REGULATION PROCESS**

(57) A method for controlling a speed of a fan of a dry cooling unit of a datacenter, the method comprising:
- estimating (202) a thermal load (Q) of the rack-mounted data processing assemblies (120A-120N),
- estimating (206) an air flow (AF) depending on the thermal load (Q) and an ambient temperature of the air flow ($T_{amb}$),
- estimating (208) a rotation speed fan of said at least one fan assembly (110A) depending on the estimated air flow (AF), and
- controlling (210) a voltage of said at least one fan assembly (110A) depending on the estimated rotation speed fan (nfan),
wherein the process (200) comprises a step (205) of modeling the air flow (AF) as a polynomial function of the ambient temperature.

FIG. 2

**Description**

**FIELD**

The present technology generally relates to the field of datacenter liquid cooling arrangements.

**BACKGROUND**

Datacenters as well as many computer processing facilities house multitudes rack-mounted electronic processing equipment. In operation, such electronic processing equipment generates a substantial amount of heat that must be dissipated in order avoid electronic component failures and ensure continued efficient processing operations.

To this end, various liquid cooling measures have been implemented to facilitate the dissipation of heat generated by the electronic processing equipment. One such measure employs liquid block cooling techniques for directly cooling one or more heat-generating processing components. This technique utilizes liquid cooling blocks having internal channels that receive cooling liquid from a cooling liquid source that are in thermal contact with the heat-generating processing components.

Depending on the access to water resources, in many cases, the preferred cooling liquid source comprises a dry cooling unit. Dry cooling units supply cooling liquid via pumps to rack-mounted electronic processing equipment as well as receive heated liquid from the electronic processing equipment and are configured to re-cool the received heated liquid for circulation back to the electronic processing equipment.

The energy consumption of datacenters is a significant issue due to several factors. Datacenters require a substantial amount of electricity to power servers and storage devices. This demand is growing rapidly, driven by an increasing use of cloud computing, big data analytics and artificial intelligence, for instance. Also, the cooling systems themselves consume a large amount of energy. The high energy consumption of datacenters contributes to greenhouse gas emissions, which have a significant impact on climate change.

Efforts to improve energy efficiency are crucial to mitigate these effects.

As such, there remains an interest in attempting to minimize the energy consumption of the cooling systems of datacenters.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

**SUMMARY**

Embodiments of the present technology have been developed based on certain drawbacks associated with conventional dry cooling techniques and implementations to improve energy efficiency.

The present technology relates to a liquid cooling method for a datacenter liquid cooling system for cooling rack-mounted data processing assemblies, the datacenter liquid cooling system comprising a cooling arrangement provided with:

a cooling unit configured to supply a cooling liquid to the rack-mounted data processing assemblies and receive a heated liquid from the rack-mounted data processing assemblies,

a forward liquid distribution circuit including a temperature sensor, and/or at least one first pump, and/or a pump pressure sensor, and/or a liquid flow volume sensor, and and/or a valve to convey the cooling liquid from the cooling unit to the rack-mounted data processing assemblies,

a return liquid distribution circuit including a temperature sensor, and/or at least one first pump, and/or a pump pressure sensor, and/or a liquid flow volume sensor, and and/or a valve to convey the heated liquid from the rack-mounted data processing assemblies back to the cooling unit and a temperature sensor,

a control module panel communicatively-coupled to the temperature sensor, pump pressure sensor, liquid flow volume sensor, temperature sensor to receive data therefrom,

each of the rack-mounted data processing assemblies comprising at least one heat-generating electronic processing element and at least one liquid cooling block arranged to be in respective thermal contact with the at least one heat-generating electronic processing element and fluidly-coupled to the forward liquid distribution circuit and/or smart flow valves respectively arranged to be fluidly-coupled to the at least one liquid cooling block of the corresponding rack-mounted data processing assembly,

the cooling unit comprising at least one fan assembly and at least one heat exchanger assembly for cooling the liquid circulating in the system and entering the cooling unit by the return liquid distribution circuit by a flow of air,

the method comprises a step of

- estimating a thermal load of the rack-mounted data processing assemblies,
- estimating an air flow depending on the thermal load and an ambient temperature of the air flow,
- estimating a fan rotation speed of said at least one fan assembly depending on the estimated air flow, and
- controlling a voltage of said at least one fan assembly depending on the estimated fan rotation speed,

wherein said voltage depends on a minimum of two functions values, a first function and a second function, the first function depending on the estimated fan rotation speed, and the second function depending on a temperature of the liquid inlet temperature.

The fan controlling method of the present technology ensures energy consumption reduction as well as better water cooling.

In some embodiments, the voltage is proportional to the minimum of the two function values.

In some embodiments, the first function is proportional to estimated fan rotation speed.

In some embodiments, the second function is a linear function of the liquid inlet temperature.

In some embodiments, fans are actuated at an air temperature lower than a set point, said set point depending on the ambient temperature and/or the thermal load, a difference between the set point and the actuation temperature being called a margin.

In some embodiments, the set point is:

- if the ambient temperature is lower than or equal to a threshold temperature, and the sampled thermal load is lower than or equal to a threshold thermal load, then the set point is a low set point;
- if the ambient temperature is lower than or equal to the threshold temperature, and the sampled thermal load is higher than the threshold thermal load, then the set point is a high set point, the high set point being higher than the low set point;
- if the ambient temperature is higher than the threshold temperature, and the sampled thermal load is lower than or equal to the threshold thermal load, then the set point depends on the ambient temperature and a first temperature value;
- if the ambient temperature is higher than the threshold temperature, and the sampled thermal load is higher than the threshold thermal load, then the set point depends on the ambient temperature and a second temperature value, higher than the first temperature value.

In some embodiments, the margin depends on the first function value.

In some embodiments, the margin is a linear function of the first function value.

In some embodiments, the second function is:

$$U_{calc} = a * T_{i-n} + b,$$

where a is a coefficient depending on an amplitude of the voltage values that can be applied to the at least one fan assembly and b is a coefficient that depends on the actuation temperature.

In some embodiments, $a = \frac{V_{max} - V_{min}}{\Delta T_{fan}}$ and $b = V_{min} - \frac{T_{i-min}}{\Delta T_{fan}} * (V_{max} - V_{min})$, where V*min* is a minimum voltage value applied to the at least one fan assembly, V*max* is a maximum voltage value applied to the at least one fan assembly, $T_{i-min}$ is the actuation temperature and $\Delta T_{fan}$ is a predetermined difference between a maximal temperature and the actuation temperature.

In some embodiments, the method comprises a step (205) of modeling the air flow (AF) as a polynomial function of the ambient temperature.

In some embodiments, the polynomial function is a six-degree polynomial:

$$AF(\Delta T, Q, T) = a_6 T_{amb}^6 + a_5 T_{amb}^5 + a_4 T_{amb}^4 + a_3 T_{amb}^3 + a_2 T_{amb}^2 + a_1 T_{amb} + a_0.$$

where all the coefficients $a_n$ are computed based on the set of values $(\Delta T, Q)$.

In some embodiments, the method comprises a step of comparing an electrical power calculated with the estimated fan speed and a real electrical power of the fan of the at least one fan assembly.

The present technology also relates to a computer program comprising instructions which, when the program is executed by a computer, cause the computer to carry out the steps of the method as already claimed.

The present technology also relates to a computer-readable medium comprising instructions which, when executed by a computer, cause the computer to carry out the steps of the method as already claimed.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.) ,USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

**BRIEF DESCRIPTION OF THE DRAWINGS**

For a better understanding of the present technology, as well as other aspects and further features thereof, reference is made to the following description which is to be used in conjunction with the accompanying drawings, where:

FIG. 1 illustrates a high-level functional block diagram of a datacenter liquid cooling system comprising a liquid arrangement, in accordance with the nonlimiting embodiments of the present technology;

FIG. 2 illustrates a flow diagram of a fan regulation process of the system of FIG. 1, in accordance with the nonlimiting embodiments of the present technology;

FIG. 3 illustrates a flow diagram of a fan regulation sub-processes of the process of FIG. 2;

FIG. 4 illustrates a high-level functional block diagram of a controller for the liquid cooling system of FIG. 1.

It should be appreciated that, unless otherwise explicitly specified herein, the drawings are not to scale.

DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the FIGs. including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some embodiments of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

Equally noteworthy, while various operations of the inventive concepts may be represented by flowchart elements arranged in certain sequential order, it should be understood that these steps may be combined, sub-divided, re-ordered, or changed to operate concurrently without departing from the teachings of the present technology. In fact, at least some of the processing steps may be executed in parallel or in series. Accordingly, the ordering, sequencing, and grouping of the processing steps is not a limitation of the present technology.

Given this fundamental understanding, the disclosed embodiments are directed to a system and method configured to minimize the damaging effects due to crucial flow component failures of a single liquid cooling arrangement by sharing liquid cooling components/resources of other liquid cooling arrangements.

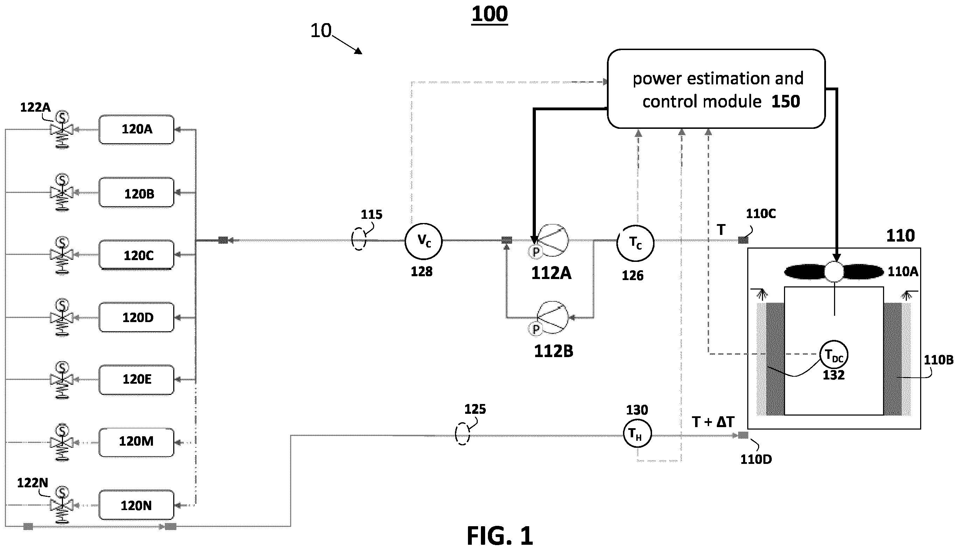

FIG. 1 illustrates a high-level functional block diagram of a datacenter liquid cooling system 10 comprising a liquid cooling arrangement 100 for cooling corresponding rack-mounted data processing assemblies, in accordance with the nonlimiting embodiments of the present technology.

As shown, the liquid cooling arrangement **100** of system **10** includes a cooling unit **110** for cooling liquid circulating in the system, for instance a dry cooling unit, a plurality of rack-mounted data processing assemblies **120A-120N,** a plurality of smart valves **122A-122N** in which each smart valve is fluidly-coupled to a respective processing assembly, a forward liquid distribution circuit **115** incorporating at least one pump **112A** for supplying cooling liquid from the dry cooling unit **110** (two pumps on **112A, 112B** on FIG. 1), a return liquid distribution circuit **125** for returning heated liquid back to the dry cooling unit **110** and, optionally, a control module panel **150** communicatively coupled to various components and sensors.

The dry cooling unit **110** may be located on any suitable stable support surface, such as, for example, the roof of a datacenter/computer processing facility building. The dry cooling unit **110** serves to dissipate thermal energy from a heated liquid circulating therethrough to the ambient environment. For example, in a datacenter or similar facility, the dry cooling unit **110** operates to receive heated liquid from the respective rack-mounted data processing assemblies **120A-120N** and extracts the thermal energy from the heated liquid by dissipating the energy into the ambient environment via the respective at least one fan assembly **110A** to thereby re-cool the heated liquid. The dry cooling unit **110** then operates to supply the re-cooled liquid back to the respective rack-mounted data processing assemblies **120A-120N.**

As shown, the dry cooling unit **110** includes at least one heat exchanger **110B** and at least one fan assembly **110A.** The heat exchanger **110B** may manifest a variety of configurations, such as, air-to-liquid heat exchanger *etc.,* and may further include evaporative cooling pads. For purposes of the instant disclosure, the exact configuration of the dry cooling unit **110** and heat exchanger **110B** is not limiting, as various configurations could be employed without departing from the concepts of the instant disclosure.

As also shown, the forward liquid distribution circuit **115** incorporates at least one pump **112A.**

Optionally, the forward liquid distribution circuit 115 also incorporates a forward "smart" control valve 119A. For purposes of the instant disclosure, the term "smart" valve refers to a valve that is pressure-independent, temperature-responsive, incorporates a differential pressure regulator to automatically adjust to system pressure changes as well as shut down given certain operational conditions. Such smart valves may comprise PICVs, ABQMs, other functionally similar valves, or combinations of valves, such as a solenoid valve combined with a control valve. In this implementation, the smart control valve **119A** is configured to sense and adjust the flow of the cooling/re-cooled liquid supplied to the processing assemblies **120A-120N.** Advantageously, the forward smart control valves **119A** are also communicatively coupled to the control module panel to provide notification about the liquid flow.

The heated liquid from the rack-mounted data processing assemblies **120A-120N** is returned back to the dry cooling unit **110** for re-cooling via the respective return liquid distribution circuit **125.** The return liquid distribution circuit **125** can also incorporate a return smart control valve **119B** that is configured to sense and adjust the flow of the heated liquid returned back to the dry cooling unit **110.**

As depicted, the dry cooling unit **110** supplies the cooling/re-cooled liquid to the rack-mounted data processing assemblies **120A-120N** at a nominal temperature T and the heated liquid returned to the dry cooling units **110, 210** is at a nominal temperature $T + \Delta T$, where $\Delta T$ represents the temperature differential between the cooling/re-cooled liquid and the heated liquid.

The liquid cooling arrangement **100** of system **10** includes a plurality of rack-mounted data processing assemblies **120A-120N** which receive the supplied cooling/re-cooled liquid via the corresponding forward liquid distribution circuit **115** to internally channel the cooling liquid to the heat-generating processing components (*e.g.*, water circulated through water blocks), and convey the heated liquid from the heat-generating processing components to the return liquid distribution circuit **125.**

The rack-mounted data processing assemblies **120A-120N** may or may not be configured with similar heat-generating processing components. As such, each of the rack-mounted data processing assemblies **120A-120N** may have different temperature and flow rate requirements for proper operations.

It will be appreciated that, while the rack-mounted data processing assemblies **120A-120N** are depicted to be arranged in a parallel configuration, it is not meant to be limiting, as the processing assemblies **120A-120N** may also be arranged in a serial or combined parallel and serial configuration without departing from the concepts of the instant disclosure.

As shown, each of the rack-mounted data processing assemblies **120A-120N** is fluidly-coupled to a smart valve **122A-122N** that dynamically controls the flow rate of the corresponding processing assembly **120A-120N** based on detected liquid temperatures.

Along the forward liquid distribution circuit **115,** liquid cooling arrangement **100** also incorporates temperature sensor **126** for measuring the temperature of the supplied cooling liquid Tc, flow pressure sensor **127** for measuring the pressure of the flow of the supplied liquid P, and a volume sensor **128** for measuring the flow rate of the supplied cooling liquid Vc.

For the return liquid distribution circuit **125,** liquid cooling arrangement **100** also incorporates temperature sensor **125** for measuring the temperature of the return heated liquid $T_H$.

As will be described in detail below, another parameter of interest are the "pinch" values of the heat exchanger assembly **110B.** That is, each heat exchanger assembly **110B** has a "hot side" and a "cold side". For the hot side, the pinch value $\Delta$Thotpinch is defined as the difference between the temperature of the hot air exiting the heat exchanger and the temperature of the hot liquid entering the heat exchanger. And, for the cold side, the pinch value $\Delta$Tcoldpinch is defined as the difference between the temperature of the fresh air entering the heat exchanger and the temperature of cold liquid exiting the heat exchanger. Both of the pinch values $\Delta$Thotpinch, $\Delta$Tcoldpinch are positive numbers.

Each of the measured $T_C$, $V_C$, $T_H$, and $T_{DC}$ ($T_{DC}$ = Tamb) values are then supplied to the control panel **150.** As will be described in detail below, based on these measured values, module **150** functions to determine the estimated power consumed by the rack-mounted data processing assemblies **120A-120N** and dynamically controls a rotational speed of dry cooling unit fan assembly **110A** to improve cooling system efficiency.

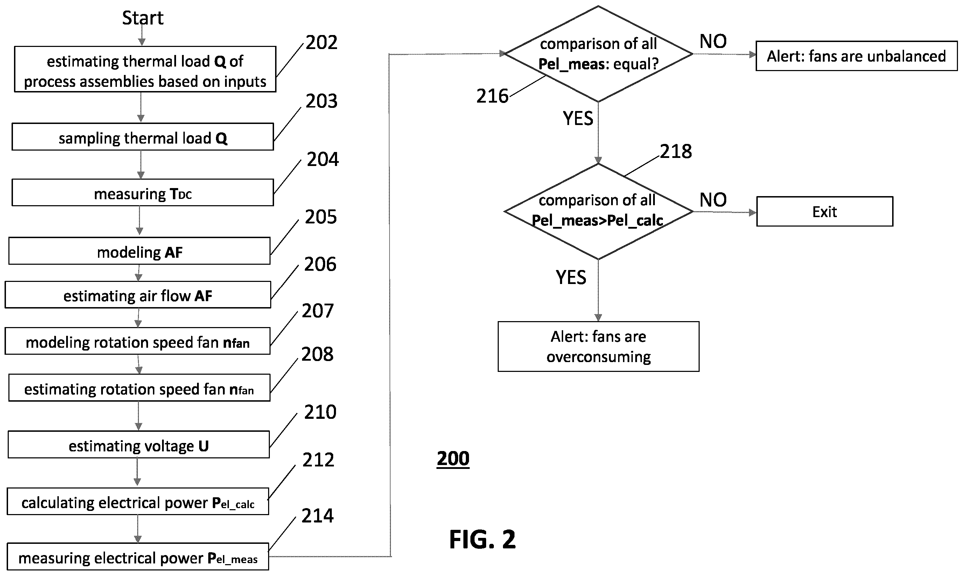

With this said, FIG. 2 illustrates a flow diagram of fan control process **200** of a liquid cooling system for rack-mounted data processing assemblies, in accordance with the non-limiting embodiments of the present technology. The power estimation and fan control process **200** may be executed by control module **150.** The execution of module **150** may be performed by a controller **600.**

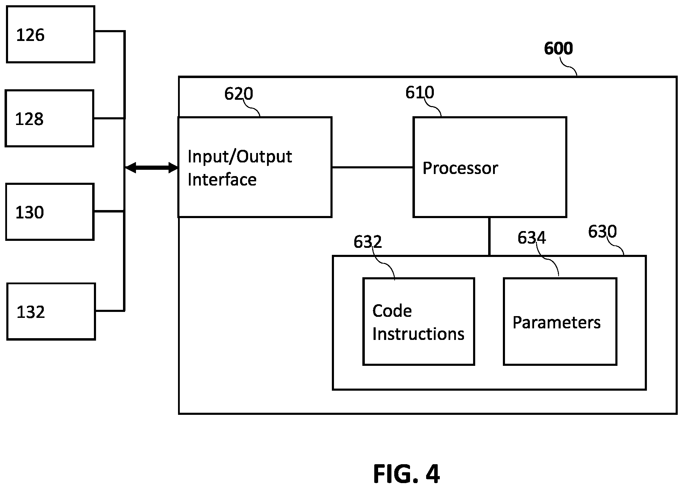

For example, such a controller is depicted by the high-level functional block diagram of FIG. 4. As shown, the controller **600** comprises a processor or a plurality of cooperating processors (represented as a processor **610** for simplicity), a memory device or a plurality of memory devices (represented as a memory device **630** for simplicity), and an input/output interface **620** (or separate input and output interfaces) allowing the controller **600** to communicate with certain components of the liquid cooling arrangement **100.** The processor **610** is operatively connected to the memory device **630** and to the input/output interface **620.** The memory device **630** includes a storage for storing parameters **634,** including for example and without limitation the above-mentioned pre-determined conductivity thresholds. The memory device **630** may comprise a non-transitory computer-readable medium for storing code instructions **632** that are executable by the processor **610** to allow the controller **600** to perform the various tasks allocated to the controller **600.**

The controller **600** is operatively connected, via the input/output interface **620,** to the components of liquid cooling arrangement **100,** such as, the temperature sensor **126** that measures the temperature of cooling liquid Tc, the temperature sensor **132** that measures the temperature of ambient dry cooling unit $T_{DC}$, the temperature sensor **130** that measures the temperature of heated liquid $T_H$, and the volume sensor **128** that measures the cooling liquid flow rate Vc, The controller **600** executes the code instructions **632** stored in the memory device 630 to implement the various above-described functions of the control module **150.**

However, it will be appreciated that in other embodiments, power estimation and fan control process **200** or portions thereof may be executed by relevant components, such as, for example, temperature sensors, volume sensors, and pumps, etc. For purposes of the instant disclosure, the exact entity or entities executing process **200** is not limiting with regard to the inventive concepts herein presented.

Returning back to FIG. 2, process **200** commences at step **202,** in which the thermal load Q of the forward liquid distribution circuit **115** is estimated. The thermal load Q of the forward liquid distribution circuit **115** corresponds to the power consumed by the rack-mounted data processing assemblies **120A-120N.** As such, process **200** determines $\Delta T$ representative of the temperature differential between the supplied cooling liquid temperature, as measured by Tc, and the returning heated liquid temperature, as measured by $T_H$. Process **200** then computes the estimated thermal load Q of the forward liquid distribution circuit **115** based on the relationship: thermal load $Q = m \cdot cp \cdot \Delta T$, where $m$ represents the mass flow rate of water and $cp$ represents the specific heat calculated as a function of the fluid average temperature.

In some embodiments, process **200** then moves to step **203** to discretizing the estimated thermal load Q by sampling the thermal load Q on subsequent regular ranges, the sampled thermal load being the maximal value on each range. For instance, the load ranks can increase each 50kW, from 50kW to 800kW. In this case, if the estimated thermal load is 425 kW, the sampled estimated thermal load is 450kW. Alternatively, the load ranks can increase each 25kW. Please note that the subsequent steps use the thermal load by heat exchanger.

Process **200** then moves to step **204** to evaluate the temperature $\Delta T$ and the ambient temperature of the dry cooling unit **110** $T_{DC}$, which depends on whether evaporative cooling pads are employed. Advantageously, the ambient temperature is considered to be comprised between -30°C and 22°C.

Then, as will be detailed, process **200** evaluates the dry cooling unit fan assembly **110A** operating parameters. Such operating parameters may include, but are not limited to, fan speed $n_{fan}$ (in rotations per minute: rpm), fan piloting voltage U (approximately between 0-10V), overall efficiency in operating point, also called fan efficiency parameter, $\eta$ (in %), and estimated fan power consumption $P_{elec\_calc}$ It will be appreciated that these operating parameters may be influenced by prevailing conditions, such as, for example, thermal load Q, ambient dry cooling unit temperature $T_{DC}$, outdoor humidity, and other factors.

At step **206,** the air flow AF is determined by the values of the ambient temperature, the $\Delta T$ and the sampled thermal load Q per exchanger. Process **200** advantageously comprises a preliminary step **205** of expressing the air flow as a polynomial function of the ambient temperature. The coefficients of each power of ambient temperature depends at least on the $\Delta T$ and the sampled thermal load.

For instance, the air flow is a 6-degree polynomial of the ambient temperature:

$$AF(\Delta T, Q, T) = a_6 T_{amb}^6 + a_5 T_{amb}^5 + a_4 T_{amb}^4 + a_3 T_{amb}^3 + a_2 T_{amb}^2 + a_1 T_{amb} + a_0.$$

where all the coefficients $a_n$ are computed based on the set of values ($\Delta T$, Q).

Coefficient $a_6$ is advantageously comprised between $10^{-5}$ and $5*10^{-4}$ $m^3/(h°C^6)$, for instance comprised between $10^{-5}$ and $5 * 10^{-5}$ $m^3/(h°C^6)$.

Coefficient $a_5$ is advantageously comprised between $10^{-5}$ and $2 * 10^{-3} m^3/(h°C^5)$, for instance comprised between $10^{-5}$ and $10^{-3} m^3/(h°C)$.

Coefficient $a_4$ is advantageously comprised between $10^{-3}$ and $1.5 * 10^{-2}$ $m^3/(h°C^4)$, for instance comprised between $10^{-3}$ and $10^{-2}$ $m^3/(h°C^4)$.

Coefficient $a_3$ is advantageously comprised between $-5 * 10^{-1}$ and $10^{-1}$ $m^3/(h°C^3)$.

Coefficient $a_2$ is advantageously comprised between 1 and 50 $m^3/(h°C^2)$, for instance comprised between 1 and 20 $m^3/(h°C^2)$.

Coefficient $a_1$ is advantageously comprised between 1 and 600 $m^3/(h°C)$, for instance comprised between 50 and 550 $m^3/(h°C)$.

The coefficient $a_0$ is advantageously comprised between 1000 and 30000 $m^3/h$, for instance comprised between 4000 and 25000 $m^3/h$.

Coefficients an are recalculated at each interrogation of the process step 205 and therefore can change each recalculation.

Then, at step **208,** process **200** evaluates the fan speed $n_{fan}$ (in rotations per minute: rpm) depending on the air flow AF and the configuration of the fan.

Advantageously, process **200** comprises a preliminary step **207** of determining the fan speed as a function of the air flow AF for the configuration of the fan, that depends on the pressure drop in the dry cooling unit, and particularly on the pressure drop induced by the specific heat exchanger assembly **110B** of the dry cooling unit, as well as on the efficiency parameter $\eta$.

For instance, per each heat exchanger, the fan speed $n_{fan}$ is a 2-degree polynomial of the air flow AF:

$$n_{fan} = b_2 AF^2 + b_1 AF + b_0$$

The fan speed $n_{fan}$ is comprised between 0 and $n_{max}$, for instance between 0 and 980 RPM.

Coefficient $b_2$ is advantageously comprised between $10^{-11}$ and $10^{-9}$ *RPM.* $(h/m^3)^2$.

Coefficient $b_1$ is advantageously comprised between $10^{-5}$ and $10^{-3}$ *RPM. $h/m^3$.*

Coefficient $b_0$ is advantageously comprised between $10^{-1}$ and $10^2$ *RPM.*

Parameter $\eta$ is comprised between 0 and 100%.

Process **200** comprises a sub-process **210** of calculating the voltage to be applied to the fan. Sub-process **210** will be detailed later. Then, at step **212**, an electrical power Pel_calc is calculated as a function of the fan speed speed $n_{fan}$.

At step **214**, process **200** comprises measuring the real electrical power Pel_meas of the fan assembly **110A.** If the system **10** comprises more than one fan, at step **216**, process **200** checks if all the fans have an electrical power that are equal with a given tolerance ($\pm$10% for instance, or $\pm$20% for instance). If they do not, process **200** issues an alert that the fans are unbalanced. If they do, then, at step **218**, there is a comparison between the calculated electrical power Pel_calc and the measured electrical power Pel_meas. If the measured electrical power Pel_meas is lower than the calculated electrical power, process **200** exits. If the measured electrical power is higher than the calculated electrical power, an alert is issued that the fans are overconsuming.

Process **200** is advantageously repeated at a regular frequency, each 30 minutes for example, each 3 minutes for example.

An example is now given, with a thermal load estimated at step **202** to 366 kW and $\Delta$T=18K. At step **203** the estimated thermal load Q is sampled to 375kW, considering increase ranks of 25kW. At step **206**, the air flow is determined by the values of the ambient temperature, the temperature differential $\Delta$T and the sampled thermal load Q. In this example, the air flow is a 6-degree polynomial of the ambient temperature:

$$AF(\Delta\mathrm{T}, \mathrm{Q}, \mathrm{T}) = a_6 T_{amb}^6 + a_5 T_{amb}^5 + a_4 T_{amb}^4 + a_3 T_{amb}^3 + a_2 T_{amb}^2 + a_1 T_{amb} + a_0,$$

where all the coefficients $a_n$ are computed based on the set of values ($\Delta$T, Q).

The ambient temperature being measured at 21°C gives an air flow value of AF(18, 300, 21)=41968 $m^3/h$. Then, at step **208**, process **200** evaluates the fan speed $n_{fan}$ (in rotations per minute: rpm) depending on the air flow AF and the configuration of the fan, with a static pressure increase of 78.11 Pa and an efficiency parameter $\eta$ of 71.4%. The fan speed is estimated to $n_{fan}$=762 RPM and a voltage of 7.8V. The associated electrical power Pel_calc equals 1003.3W.

Sub-process **210** aims at smoothing the voltage U that is being applied to the fan assembly 110A instead of working either to 0V or a maximal value, like, for instance, 9V or 10V.

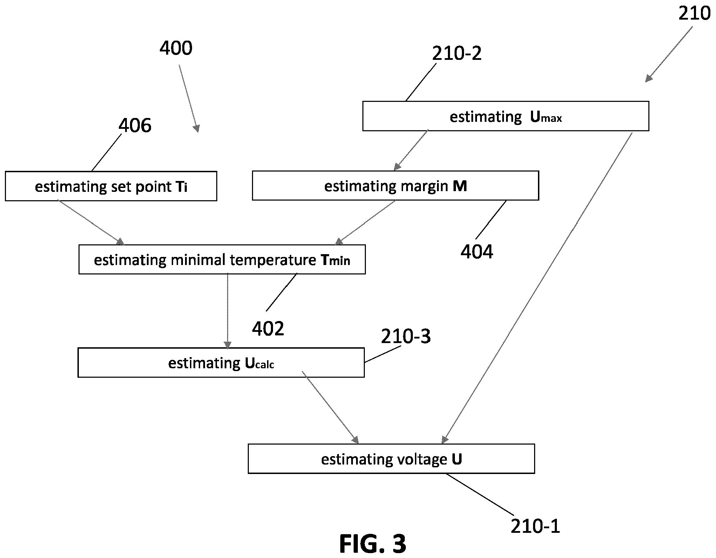

As seen in FIG. 3, sub-process **400** comprises a step **402** of determining an air temperature, called actuation temperature, or minimal temperature, such that the fans are to be actuated some degrees before the set temperature $T_i$. The actuation temperature of Tc, referenced to as $T_{i\text{-}min}$ can be expressed as

$$T_{i-min} = T_i - M,$$

where M is a margin, calculated at step **404**, will be detailed later.

At step **406**, sub-process **400** comprises determining the set point $T_i$ depending on the ambient temperature $T_{amb}$ and the sampled thermal load Q.

Advantageously, the set point $T_j$ is chosen as follows:

- If the ambient temperature is lower than or equal to a threshold temperature, for instance 22°C, and the sampled thermal load Q is lower than or equal to a threshold thermal load, for example 500kW, then the set point is a lower set point $T_{iL}$, for example 25°C, (meaning the pinch is 3K).

This configuration takes advantage of the cold ambient air that can cool quite easily the liquid entering the dry cooling since the thermal load is rather low;

- If the ambient temperature is lower than or equal to a threshold temperature, for instance 22°C, and the sampled thermal load Q is higher than the threshold thermal load, for example 500kW, then the set point is a higher set point $T_{iH}$, for example 27°C, (meaning the pinch is 5K).

This configuration takes advantage of the cold ambient air but the thermal load being higher (compared to the previously described configuration), the set point is chosen higher;

- If the ambient temperature is higher than the threshold temperature, for instance 22°C, and the sampled thermal load Q is lower than or equal to the threshold thermal load, for example 500kW, then the set point is chosen as

$$T_i = T_{amb} + P_{inch}^L$$ , where $P_{inch}^L$ is for instance of 3K,

This configuration takes into account the not so fresh air and the low thermal load;

- If the ambient temperature is higher than the threshold temperature, for instance 22°C, and the sampled thermal load Q is higher than the threshold thermal load, for example 500kW, then the set point is chosen as $T_i = T_{amb} + P_{inch}^H$ , where $P_{inch}^H$ is for instance of 5K;

This configuration takes into account the not so fresh air and the high thermal load.

The water temperature is controlled to not excess a maximal temperature $T_M$, this maximal temperature being written as equal to $T_{i\text{-}min} + \Delta T_{fan}$. The difference $\Delta T_{fan}$ is predetermined. $\Delta T_{fan}$ can be chosen between 1K and 15K, for instance between 5K and 10K. For instance, $\Delta T_{fan}$ = 9K.

Sub-process **210** is now described with reference to FIG. 3.

Sub-process **210** comprises a step **210-1** of calculating the voltage U as a function, for instance a function be proportional of a minimum of two functions, a first function called Umax, and a second function called U$_{calc}$, as explained below:

$$U = C * min(U_{max}, U_{calc}),$$

where C is a coefficient chosen for instance chosen between 0.01 and 100, for instance between 1 and 10, for instance 1.

Sub-process **210** comprises a step **210-2,** previous to step **210-1,** of calculating Umax. The function Umax is proportional to the fan speed n$_{fan}$. For instance, U is chosen to be comprised between 0V and 10V, such that it can be expressed as:

$$U_{max} = \frac{n_{fan}}{n_{max}} * V_{max},$$

where $V_{max}$ is a maximal voltage value that can be applied to the fan, for instance 10V, and $n_{max}$ is a maximal speed value. For example, $V_{max}$ = 10V and $n_{max}$=980RPM:

$$U_{max} = \frac{n_{fan}}{980} * 10.$$

Sub-process **210** comprises a step **210-3,** previous to step **210-1,** of calculating Ucalc. The function Ucalc depends on temperature of the liquid at the inlet of the dry cooling unit $T_{i\text{-}n}$ and on the difference $\Delta T_{fan}$. Advantageously, the function Ucalc is a linear function of the incremental temperature $T_{i\text{-}n}$:

$$U_{calc} = a * T_{i-n} + b,$$

where

$$a = \frac{V_{max} - V_{min}}{\Delta T_{fan}} \text{ and } b = V_{min} - \frac{T_{i-min}}{\Delta T_{fan}} * (V_{max} - V_{min}).$$

$V_{min}$ is the minimal voltage that can be applied to the fans.

Advantageously, $V_{min}$ = 0 V, $V_{max}$ = 10 V. Alternatively or additionally, $\Delta T_{fan}$ = 9K.

Advantageously, the margin M is a function of $U_{max}$ (in percentage). For instance, M is a linear function of $U_{max}$.

For instance, $M = c * U_{max} + d$, where c and d are coefficients.

The margin M is a value to calculate the set point for fans kick ON; so it is in °C.

Coefficient c can depend on the amplitude of the fan voltage and coefficient d can depend on coefficient c. For example $c = \frac{V_{max} - V_{min}}{A_{\%max} - A_{\%min}}$, and $d = V_{max} - c * A_{\%max}$, where $A_{\%max}$ is the maximal percentage of the voltage that can be applied to the fans and $A_{\%min}$ is the minimal percentage of the voltage that can be applied to the fans. For instance, $V_{min}$ is comprised between 0V and 2V, $V_{max}$ is comprised between 9 and 10V, $A_{\%min}$ is comprised between 5 and 15% and $A_{\%max}$ is comprised between 90 and 100%.

Advantageously, sub-process 210 is implemented at a regular frequency, for instance each minute, which ensures an optimized control of the fans.

An example is now given, with a thermal load estimated at step **202** to 600kW, a thermal load per exchanger of 300kW, and ΔT=20K. At step **203** the estimated thermal load Q is sampled to 300kW. At step **206,** the air flow is determined by the values of the ambient temperature, the temperature differential ΔT and the sampled thermal load Q, as is shown in FIG. 3. In this example, the air flow is a 6-degree polynomial of the ambient temperature:

$$AF(\Delta\text{T}, \text{Q}, \text{T}) = a_6 T_{amb}^6 + a_5 T_{amb}^5 + a_4 T_{amb}^4 + a_3 T_{amb}^3 + a_2 T_{amb}^2 + a_1 T_{amb} + a_0,$$

where coefficient $a_6$ is $2.3 * 10^{-5} m^3/(hK^6)$ , coefficient $a_5$ is $1.2 * 10^{-3} m^3/(hK^5)$ , coefficient $a_4$ is $1.2 * 10^{-2} m^3/(hK^4)$, coefficient $a_3$ is $0{,}06\ m^3/(hK^3)$, coefficient $a_2$ is $10{,}6\ m^3/(hK^2)$, coefficient $a_1$ is $496\ m^3/(hK)$, and coefficient $a_0$ is $1121593\ m^3/h$.

The ambient temperature being measured at 13,1°C upstream the heat exchanger gives an air flow value of AF(18, 300, 13,1)=30966 $m^3/h$. Then, at step **208,** process **200** evaluates the fan speed $n_{fan}$ (in rotations per minute: rpm) depending on the air flow AF and the configuration of the fan, with a static pressure increase of 107 Pa. The fan speed is estimated to $n_{fan}$=603 RPM (99, AJ) and a maximal voltage $U_{max}$ of 6,2V (step **210-2**). The associated electrical power Pel_calc equals 587 W.

The parameters are the following: $U_{min} = 0\ V$ (predetermined) and $\Delta T_{fan} = 9K$ (predetermined). The inlet water temperature is measured: $T_{i\text{-}n}$= 22,7 °C.

Given that the ambient temperature $T_{amb} \leq 22$°C and Q>500 kW, then the pinch is chosen to be 5K and $T_i$ = 27°C.

The margin M is calculated with $V_{max} = 9.5V$, $V_{min} = 1.8V$, $A_{\%max} = 100\%$ and $A_{\%min} = 10\%$ , such that $c = \frac{9.5 - 1.8}{90} = 0.0856\ V$ and $d = V_{max} - c * A_{\%max} = 9.5 - 0.0856 * 100 = 0.94$ and $M = 0.0856 * (6.2 * 10) * 100 + 0.94 = 6.20$.

The minimal temperature is therefore equal to 27-6.20=20.8°C and $U_{calc} = \frac{10}{9} * 22{,}7 + \frac{-10*20.8}{9} = 2.1\ V$.

The voltage to be applied to the fan being the minimal of Ucalc and Umax is Ucalc=2.1 V, meaning that the fan speed $n_{fan}$ equals 21 % of the $n_{max}$.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

Please note that the steps 202, 206, 208 can be made either by modelling but also measuring respectively the thermal load, the airflow and the fan rotation speed.

The heat exchangers can be of any appropriate kinds a chille, like cooling tower or even a plate heat exchange.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

**Claims**

1. A liquid cooling method (50) for a datacenter liquid cooling system (10) for cooling rack-mounted data processing assemblies (120A-120N), the datacenter liquid cooling system comprising a cooling arrangement (100) provided with:

a cooling unit (110) configured to supply a cooling liquid to the rack-mounted data processing assemblies (120A-120N) and receive a heated liquid from the rack-mounted data processing assemblies (120A-120N),
a forward liquid distribution circuit (115) including a temperature sensor (126), to convey the cooling liquid from the cooling unit to the rack-mounted data processing assemblies (120A-120N),
a return liquid distribution circuit (125) to convey the heated liquid from the rack-mounted data processing assemblies (120A-120N) back to the cooling unit (110) and a temperature sensor (130),
a control module panel (150) communicatively-coupled to the temperature sensor (126), to receive data therefrom,
each of the rack-mounted data processing assemblies (120A-120N) comprising at least one heat-generating electronic processing element and at least one liquid cooling block arranged to be in respective thermal contact with the at least one heat-generating electronic processing element and fluidly-coupled to the forward liquid distribution circuit (115),
the cooling unit (110) comprising at least one fan assembly (110A) and at least one heat exchanger assembly (110B) for cooling the liquid circulating in the system (10) and entering the cooling unit (110) by the return liquid distribution circuit (125) by a flow of air,

the method comprises a step of

- estimating (202) a thermal load (Q) of the rack-mounted data processing assemblies (120A-120N),
- estimating (206) an air flow (AF) depending on the thermal load (Q) and an ambient temperature of the air flow ($T_{amb}$),
- estimating (208) a fan rotation speed of said at least one fan assembly (110A) depending on the estimated air flow (AF), and
- controlling (210) a voltage of said at least one fan assembly (110A) depending on the

estimated fan rotation speed (nfan),
wherein said voltage depends on a minimum of two functions values, a first function (Umax) and a second function (Ucalc), the first function (Umax) depending on the estimated fan rotation speed (nfan), and the second function (Ucalc) depending on a temperature of the liquid inlet temperature.

2. The method of claim 1, wherein the voltage is proportional to the minimum of the two function values ($U_{max}$, $U_{calc}$).

3. The method of claim 1 or 2, wherein the first function (Umax) is proportional to estimated fan rotation speed (nfan).

4. The method of one of the preceding claims, wherein the second function (Ucalc) is a linear function of the liquid inlet temperature.

5. The method of one of the preceding claims, wherein fans are actuated at an air temperature lower than a set point, said set point depending on the ambient temperature ($T_{amb}$) and/or the thermal load (Q), a difference between the set point and the actuation temperature being called a margin (M).

6. The method of the preceding claims, wherein the set point is:

- if the ambient temperature ($T_{amb}$) is lower than or equal to a threshold temperature, and the sampled thermal load (Q) is lower than or equal to a threshold thermal load, then the set point is a low set point (TiL);
- if the ambient temperature ($T_{amb}$) is lower than or equal to the threshold temperature, and the sampled thermal load (Q) is higher than the threshold thermal load, then the set point is a high set point (TiH), the high set point (TiH) being higher than the low set point (TiL);
- if the ambient temperature ($T_{amb}$) is higher than the threshold temperature, and the sampled thermal load (Q) is lower than or equal to the threshold thermal load, then the set point depends on the ambient temperature and a first temperature value;
- if the ambient temperature ($T_{amb}$) is higher than the threshold temperature, and the sampled thermal load (Q) is higher than the threshold thermal load, then the set point depends on the ambient temperature and a second temperature value, higher than the first temperature value.

7. The method of the claim 5 or 6, wherein the margin depends on the first function value.

8. The method of the preceding claim, wherein the margin is a linear function of the first function value.

9. The method of one of the claims 5 to 8, wherein the second function is:

$$U_{calc} = a * T_{i-n} + b,$$

where a is a coefficient depending on an amplitude of the voltage values that can be applied to the at least one fan assembly (110A) and b is a coefficient that depends on the actuation temperature.

10. The method of the preceding claim, wherein $a = \frac{V_{max} - V_{min}}{\Delta T_{fan}}$ and $b = V_{min} - \frac{T_{i-min}}{\Delta T_{fan}} * (V_{max} - V_{min})$, where $V_{min}$ is a minimum voltage value applied to the at least one fan assembly (110A), $V_{max}$ is a maximum voltage value applied to the at least one fan assembly (110A), $T_{i-min}$ is the actuation temperature and $\Delta T_{fan}$ is a predetermined difference between a maximal temperature and the actuation temperature.

11. The method of any of the preceding claims, comprising a step (205) of modeling the air flow (AF) as a polynomial function of the ambient temperature.

12. The method of the preceding claim, wherein the polynomial function is a six-degree polynomial:

$$AF(\Delta T, Q, T) = a_6 T_{amb}^6 + a_5 T_{amb}^5 + a_4 T_{amb}^4 + a_3 T_{amb}^3 + a_2 T_{amb}^2 + a_1 T_{amb} + a_0$$

13. The method of any of the preceding claims, comprising a step (218) of comparing an electrical power calculated with the estimated fan speed and a real electrical power of the fan of the at least one fan assembly.

14. A computer program comprising instructions which, when the program is executed by a computer, cause the computer to carry out the steps of the method of any of claims 1 to 13.

15. A computer-readable medium comprising instructions which, when executed by a computer, cause the computer to carry out the steps of the method of any of claims 1 to 14.

**FIG. 1**

EP 4 766 051 A1

Start

estimating thermal load **Q** of process assemblies based on inputs  202

sampling thermal load **Q**  203

measuring **T**DC  204

modeling **AF**  205

estimating air flow **AF**  206

modeling rotation speed fan **n**fan  207

estimating rotation speed fan **n**fan  208

estimating voltage **U**  210

calculating electrical power **P**el_calc  212

measuring electrical power **P**el_meas  214

comparison of all **Pel_meas**: equal?  216 → NO → Alert: fans are unbalanced

YES

comparison of all **Pel_meas>Pel_calc**  218 → NO → Exit

YES

Alert: fans are overconsuming

**200**

**FIG. 2**

**FIG. 3**

**FIG. 4**

Europäisches
Patentamt

European
Patent Office

Office européen
des brevets

## EUROPEAN SEARCH REPORT

Application Number

EP 24 30 7256

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/201902 A1 (MICROSOFT TECHNOLOGY LICENSING LLC [US]) 23 June 2022 (2022-06-23) * paragraphs [0022], [0027] - [0035], [0038], [0040], [0046] - [0048]; figures 1-2c, 4a,4b * | 1-15 | INV. H05K7/20 |
| A | US 2009/268404 A1 (CHU RICHARD C [US] ET AL) 29 October 2009 (2009-10-29) * paragraphs [0033] - [0036], [0043], [0047], [0048]; figures 3,7A,7B * | 1-15 | |

|  |
|---|
| **TECHNICAL FIELDS SEARCHED (IPC)** |
| H05K |

The present search report has been drawn up for all claims

| Place of search | Date of completion of the search | Examiner |
|---|---|---|
| The Hague | 5 June 2025 | Schneider, Florian |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

   

& : member of the same patent family, corresponding
   document

EPO FORM 1503 03.82 (P04C01)

## EP 4 766 051 A1

### ANNEX TO THE EUROPEAN SEARCH REPORT
### ON EUROPEAN PATENT APPLICATION NO.

EP 24 30 7256

This annex lists the patent family members relating to the patent documents cited in the above-mentioned European search report.
The members are as contained in the European Patent Office EDP file on
The European Patent Office is in no way liable for these particulars which are merely given for the purpose of information.

05-06-2025

| Patent document cited in search report | Publication date | Patent family member(s) | Publication date |
|---|---|---|---|
| US 2022201902 A1 | 23-06-2022 | US 2022201902 A1 | 23-06-2022 |
| | | US 2024357775 A1 | 24-10-2024 |
| US 2009268404 A1 | 29-10-2009 | NONE | |

EPO FORM P0459

For more details about this annex : see Official Journal of the European Patent Office, No. 12/82